Europäisches Patentamt

(19) European Patent Office

Office européen des brevets

(11) Numéro de publication : **0 437 146 A1**

# (12) DEMANDE DE BREVET EUROPEEN

(21) Numéro de dépôt : **90403785.0**

(51) Int. Cl.⁵ : **B65G 65/00, H01L 21/00**

(22) Date de dépôt : **27.12.90**

(30) Priorité : **29.12.89 FR 8917450**

(43) Date de publication de la demande :
**17.07.91 Bulletin 91/29**

(84) Etats contractants désignés :
**DE GB NL**

(71) Demandeur : **COMMISSARIAT A L'ENERGIE ATOMIQUE**
**31-33, rue de la Fédération**
**F-75015 Paris (FR)**

(72) Inventeur : **Cruz, Didier**
**39 rue Marbeuf**
**F-38100 Grenoble (FR)**

(74) Mandataire : **Mongrédien, André et al**
**c/o BREVATOME 25, rue de Ponthieu**
**F-75008 Paris (FR)**

(54) **Dispositif de rangement d'objets plats dans une cassette avec rayonnages intermédiaires.**

(57)    Le dispositif permet le rangement d'objets plats (20) dans une cassette de rangement (18) à l'aide d'une cassette intermédiaire (60), dans laquelle il est ainsi possible de stocker temporairement certains objets plats (20).

Le dispositif comprend un ensemble de préhension (50) comportant un nombre de pistes (2) correspondant au nombre de rayonnages de la cassette de rangement (18). Il comprend également une cassette intermédiaire (60) dont chaque rayonnage est placé en correspondance avec les pistes (2) de l'ensemble de préhension. Pour effectuer le dépôt ou le prélèvement d'un objet plat (20) dans la cassette de rangement (18), il est ainsi possible de débarrasser l'ensemble de préhension (50) de certains objets plats (21) pouvant faire interférence lors des manoeuvres de pénétration des pistes (2) dans la cassette de rangement (18). La manipulation des objets plats sur les pistes (2) se fait par un soulèvement pneumatique.

Application à la manipulation des plaques de silicium destinées à la fabrication de circuits intégrés.

FIG. 1A

EP 0 437 146 A1

# DISPOSITIF DE RANGEMENT D'OBJETS PLATS DANS UNE CASSETTE AVEC RAYONNAGES INTERMEDIAIRES

Le domaine de l'invention est celui de la manipulation d'objets plats devant être rangés dans une cassette ou sortis de cette cassette. C'est en particulier le cas lors de la fabrication des circuits intégrés, où des plaques de silicium sont ainsi manipulées, rangées dans des cassettes, puis doivent en être extraites, de manière à pouvoir subir d'autres opérations de fabrication.

Pour la fabrication des circuits intégrés sur des plaques de silicium, la gestion et la manipulation des plaques se fait à partir de cassettes de rangement dans lesquelles elles sont placées horizontalement. Chaque cassette possède une série de rayonnages constitués de supports latéraux, pouvant recevoir horizontalement une série de plaques de dimensions identiques. La manipulation des plaques impose l'utilisation d'un système permettant de prendre une plaque stockée dans une cassette et de remettre cette plaque dans une quelconque cassette sur n'importe quel rayonnage libre.

Pour effectuer ces opérations de préhension et de remise en place d'une plaque dans une cassette, il est connu d'utiliser un mécanisme de préhension composé principalement d'un doigt préhenseur capable de prélever une seule plaque hors de la cassette et de l'y remettre. Compte tenu du très court espace en hauteur séparant deux plaques adjacentes, de l'ordre de 5 mm pour la norme "SEMI-ENGINEERING", les mouvements de ce doigt préhenseur doivent être très précis. En effet, tout système préhenseur doit pouvoir pénétrer sous la plaque à prélever sans rayer la plaque supérieure. Le positionnement en hauteur du doigt préhenseur est assuré par un dispositif mécanique très précis, onéreux, entrainant en translation verticale le doigt et son support. Le doigt préhenseur peut également rester fixe, le mouvement précis en translation verticale étant alors assuré par un autre dispositif mécanique entrainant la cassette. Dans ce dernier cas, c'est la précision du mécanisme de translation de la cassette qui est très coûteux.

Un premier but de l'invention est de fournir un dispositif de préhension et de lâchage d'une plaque dans une cassette qui soit extrêmement fin, c'est-à-dire qui puisse pénétrer entre les rayonnages de la cassette sans difficulté. Il faut, de plus, que sa manipulation soit aisée et le prix diminué, par rapport au dispositif préhenseur du type précédemment décrit.

Un deuxième but de l'invention est de pouvoir effectuer simultanément la préhension d'une ou plusieurs plaques dans la cassette à différents étages, et la pose d'autres plaques dans la cassette à des étages différents, sans qu'il y ait interférence sur un même étage.

A cet effet, l'objet principal de l'invention est un dispositif de rangement d'objets plats stockés dans une cassette de rangement, parallèlement entre eux, posés sur des rayonnages constitués de supports latéraux qui sont d'un nombre déterminé N et séparés les uns des autres d'un écart déterminé E.

Selon l'invention, le dispositif comprend :
– un ensemble de préhension comportant un même nombre N de pistes horizontales, séparées les unes des autres du même écart déterminé E et terminées chacune par une extrémité de préhension où sont placés des moyens de préhension et de lâchage d'un objet plat sur un rayonnage correspondant de la cassette ;
– une cassette intermédiaire dotée d'un deuxième nombre déterminé M, égal ou supérieur au premier nombre N de rayonnages, espacés entre eux de l'écart E, pour accueillir temporairement des objets plats ; et
– des moyens de translation horizontale et relative entre l'ensemble de préhension et la cassette intermédiaire, pour permettre le transfert dans les deux sens d'au moins un objet plat entre l'ensemble de préhension et la cassette intermédiaire.

Ceci permet de stocker temporairement des objets plats se trouvant sur l'ensemble de préhension, de manière à ne pas faire interférence, au niveau de leur rayonnage, avec des objets plats placés dans la cassette de stockage sur le rayonnage correspondant.

Une réalisation préférentielle de l'ensemble de préhension et de lâchage des objets plats selon l'invention prévoit que la préhension d'un objet plat s'effectue par soulèvement d'une partie mobile de la piste et que le lâchage de l'objet plat se fait par la redescente de la même partie mobile de la piste.

La réalisation préférentielle de tels moyens de préhension prévoit que ceux-ci sont constitués chacun d'un soufflet déformable, fixé à la fois à la piste par une première extrémité inférieure et à la partie mobile par une deuxième extrémité supérieure et que ledit soufflet est relié à une source de dépression.

Selon un aspect de l'invention, chaque rayonnage de la cassette intermédiaire est constitué de deux supports latéraux ménageant un espace entre eux pour permettre l'interpénétration de la piste correspondante de l'ensemble de préhension par translation parallèle aux supports latéraux, la surface supérieure de la piste mobile se trouvant très légèrement en-dessous de la surface supérieure des supports latéraux de l'étage correspondant de la cassette intermédiaire. La course verticale de la piste mobile, lors d'une montée, doit être suffisante pour provoquer un décollement d'un objet plat posé sur les supports latéraux de la cassette intermédiaire et, lors d'une redescente de la piste mobile, permettre un dépôt de l'objet plat sur les supports latéraux de la cassette intermédiaire.

De manière préférentielle, le dispositif est complété par des moyens de commande sélective, pour actionner indépendamment les uns des autres les ensembles de préhension et de lâchage, afin de saisir ou reposer n'importe quel objet plat placé dans la cassette de rangement ou la cassette intermédiaire, ou posé sur une piste.

La principale réalisation de l'interpénétration de l'ensemble de préhension dans la cassette intermédiaire se fait par des évidements pratiqués à l'arrière de chacune des pistes de l'ensemble de préhension, pour permettre à la cassette intermédiaire de venir par l'arrière, jusqu'à la piste mobile.

Dans ce cas, on prévoit des moyens de translation verticale de la cassette intermédiaire, pour venir mettre en correspondance, de façon décalée, les rayonnages respectifs de la cassette intermédiaire et de l'ensemble de préhension.

Dans une variante de réalisation, l'interpénétration de l'ensemble de préhension dans la cassette intermédiaire se fait par l'avant des pistes, dont la largeur est inférieure à la largeur de l'espace libre entre les supports latéraux de la cassette de stockage et les supports latéraux de la cassette intermédiaire, de manière à pouvoir traverser ces deux cassettes dans le même mouvement de translation.

Dans ce cas, on prévoit des moyens de translation verticale de l'ensemble de préhension, pour venir mettre en correspondance, de façon décalée, les rayonnages respectifs de la cassette intermédiaire et de l'ensemble de préhension.

L'invention et ses différentes caractéristiques techniques seront mieux comprises à la lecture de la description suivante, donnée à titre indicatif et non limitatif.

Les différentes figures annexées représentent respectivement :

— figures 1A, 1B, 1C, 1D et 1E, des schémas de principe du fonctionnement du dispositif selon l'invention ;

— figures 2A et 2B, deux vues latérales de l'extrémité d'une piste utilisée dans le dispositif selon l'invention et équipée de ces moyens de préhension ;

— figure 3, une vue de face en coupe d'une cassette de rangement dans laquelle sont entreposés des objets plats, entre lesquels s'insère le dispositif selon l'invention ;

— figure 4, une vue en coupe latérale montrant trois phases de préhension d'un objet plat dans la cassette de rangement, à l'aide du dispositif selon l'invention ;

— figure 5, une vue en perspective d'une première réalisation du dispositif selon l'invention, placé en regard d'une cassette de rangement ;

— figure 6, un schéma en perspective du dispositif selon l'invention ;

— figures 7A, 7B, 7C et 7D, des schémas de principe représentant le fonctionnement et l'utilisation du dispositif selon l'invention équipé d'un perfectionnement ; et

— figures 8A, 8B, 8C, des vues latérales d'une variante de réalisation du dispositif selon l'invention, adaptée au principe schématisé par les figures 7A, 7B, 7C et 7D.

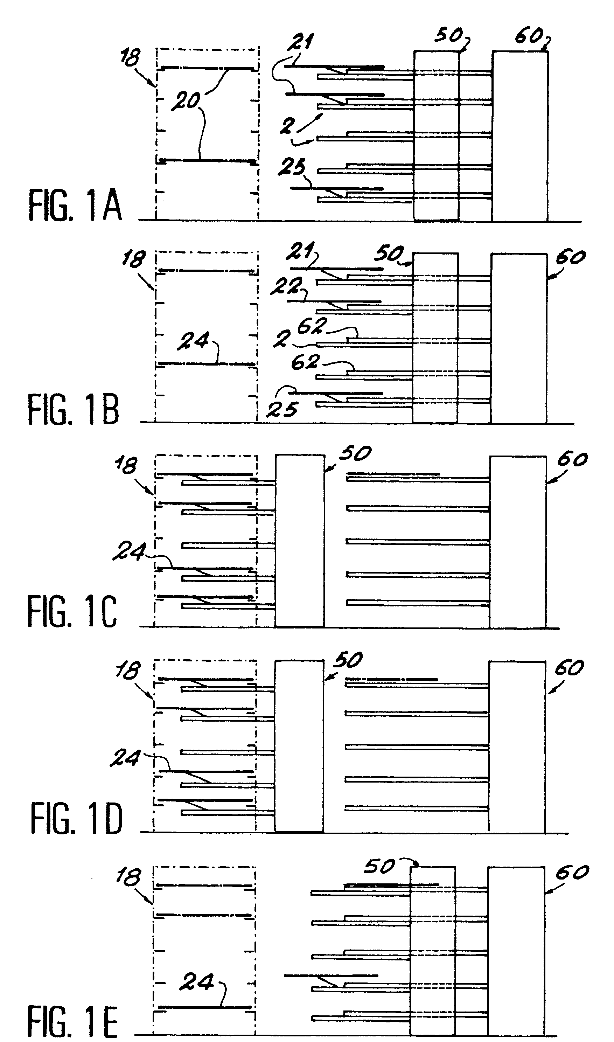

Un des problèmes que permet de résoudre l'invention apparaît sur la figure 1A. L'ensemble de droite est le dispositif selon l'invention dans une première réalisation. Sur la gauche de la figure, se trouve une cassette de rangement 18 contenant des objets plats 20, tels que des plaques de silicium, destinées à rentrer dans la fabrication des circuits intégrés en microélectronique.

Le dispositif selon l'invention permet de ranger des objets plats 20, 21, 22, 25, dans la cassette de rangement 18. On entend par rangement le fait d'aller poser des objets plats dans la cassette de rangement 18, mais également l'action de les y prendre, pour les mettre dans une autre cassette de stockage ou de rangement, ou même pour les y remettre sur un rayonnage différent.

Sur cette figure 1A, on constate que, si on désire mettre à l'intérieur de la cassette de rangement 18 les deuxième et cinquième objets plats 22 et 25, placés respectivement sur les deuxième et cinquième pistes 2 du dispositif de rangement selon l'invention, cette opération est rendue impossible. En effet, la première piste du dispositif de rangement et le premier rayonnage de la cassette de rangement 18 sont tous les deux occupés par un objet plat. Une tentative de pénétration des deuxième et cinquième objets plats 22 et 25 dans la cassette de rangement 18, à leur rayonnage correspondant, amènera inévitablement un télescopage du premier objet plat 21 du dispositif de rangement avec l'objet plat placé sur le premier rayonnage de la cassette de stockage 18.

Selon l'invention, on dispose d'une cassette intermédiaire repérée 60 comportant un premier nombre de pistes 62 au moins égal au nombre de pistes 2 de l'ensemble de préhension repéré 50. Chaque piste intermédiaire 62 de la cassette intermédiaire 60 est placée en correspondance avec une piste 2 de l'ensemble de préhension 50. Ces deux ensembles de pistes 2 et 62 peuvent être placés très près l'un de l'autre. Les pistes intermédiaires 62 ont pour fonction de recevoir temporairement un ou plusieurs objets plats, en l'occurrence l'objet plat 21 placé sur le premier rayonnage, pour que l'ensemble de préhension 50 puisse aller poser les deuxième et cinquième objets plats 22 et 25 dans la cassette de rangement 18, à leur rayonnage respectif.

L'opération représentée par la figure 1B, consiste à déposer le premier objet plat 21 sur le rayonnage intermédiaire correspondant.

A cet effet et pour effectuer les manipulations dans la cassette de rangement 18, chaque piste 2 est dotée de moyens de préhension et de lâchage d'un objet plat.

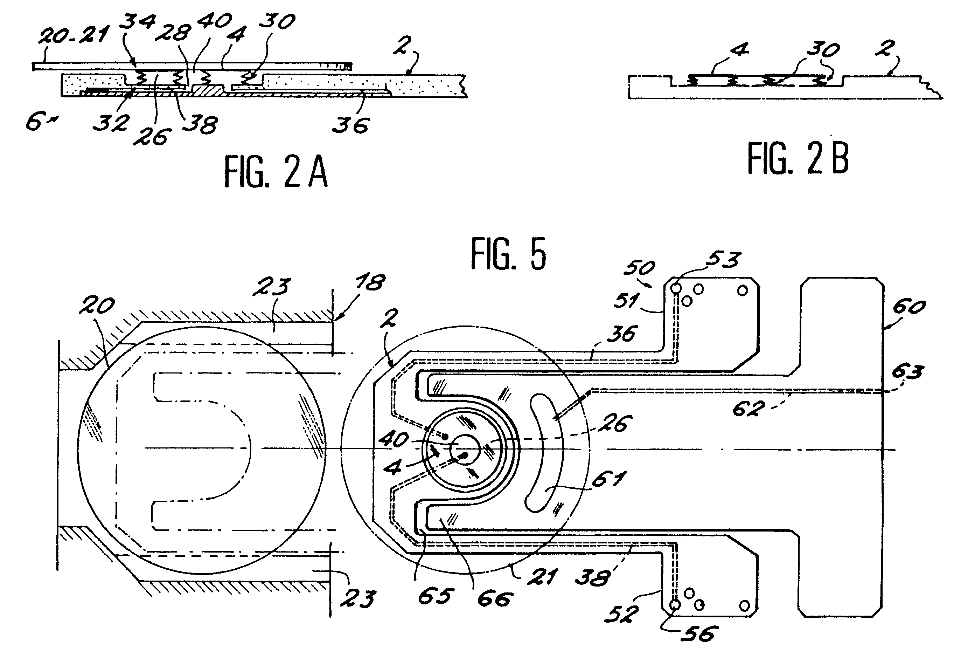

Dans la réalisation qui est décrite dans cette description, ces moyens de préhension et de lâchage opèrent en maintenant en position haute les objets plats 22 et 25, qui doivent être rangés dans la cassette de rangement 18, et en descendant l'objet plat 21, qui doit être déposé sur le rayonnage intermédiaire correspondant. Le détail de la réalisation de ces moyens de préhension et de lâchage est expliqué plus loin, en regard des figures 2A et 2B.

Une fois l'objet plat 21 posé sur son rayonnage intermédiaire correspondant de la cassette intermédiaire 60, l'ensemble de préhension 50 peut alors s'engager à l'intérieur de la cassette de rangement 18. Ceci se fait de manière à ce que les deux objets plats 22 et 25 à déposer dans la cassette de rangement 18 se trouvent juste au-dessus de leur rayonnage de stockage respectif de la cassette de rangement 18, comme représenté sur la figure 1C.

La figure 1D représente les deuxième et cinquième objets plats 22 et 25 posés sur leur rayonnage de stockage. Elle représente également les moyens de préhension et de lâchage de la quatrième piste de l'ensemble de préhension en train de soulever un objet 24, qui était auparavant stocké dans la cassette de stockage 18.

Enfin, la figure 1E montre l'ensemble de préhension qui est sorti de la cassette de stockage 18 avec le quatrième objet plat 24. Les deuxième et cinquième objets plats 22 et 25 sont alors rangés dans la cassette de rangement 18.

En référence aux figures 2A et 2B, les moyens de préhension et de lâchage peuvent être réalisés à l'aide d'un soufflet pneumatique 30, soulevant ou abaissant une partie mobile 4 de la piste 2. Celui-ci est placé à l'extrémité 6 de chaque piste 2 de l'ensemble de préhension, en-dessous de la partie mobile 4. L'extrémité inférieure 32 du soufflet 30 est fixée sur la piste 2. L'extrémité supérieure 34 du soufflet 30 est fixée à la partie mobile 4. L'intérieur du soufflet 30 est relié, par une première conduite 36 placée à l'intérieur de la piste 2, à des moyens de mise sous pression, non représentés sur ces figures.

La mise sous pression d'une chambre principale 26 du soufflet 30 conduit à une élévation de l'extrémité supérieure 34 de celui-ci et à un soulèvement d'un objet plat 20, lorsque le dispositif est placé juste en-dessous d'un tel objet 20. La remise à la pression ambiante du soufflet 30 conduit à la redescente par gravité de l'extrémité supérieure 34 du soufflet 30, et par là-même, à la redescente de l'objet plat 20. Lorsque cette redescente s'effectue au-dessus de supports latéraux 23 d'une cassette 18, l'objet plat se trouve posé sur ces supports latéraux 23.

Chaque partie mobile 4 des pistes 2 est munie d'un orifice 40 débouchant sur la surface supérieure de la partie mobile 4. Il est relié par une chambre centrale 28 et une deuxième conduite 38 à des moyens de mise en dépression, non représentés sur ces figures.

Lorsqu'une dépression règne dans la conduite 38 et l'orifice 40, un phénomène de succion apparaît à la surface supérieure de la partie mobile 4 et crée une force de rétention sur l'objet plat 20, placé sur cette surface supérieure de la partie mobile 4. Ceci permet de maintenir l'objet plat 20 pendant les différentes manipulations du dispositif. Cette disposition n'est pas indispensable au fonctionnement du dispositif.

Pour pouvoir être utilisé dans des cassettes, dont l'intervalle en hauteur entre les différents rayonnages est très restreint, il est nécessaire que le soufflet 30 puisse s'écraser en position basse, pour se loger dans l'épaisseur de la piste. Ceci permet l'insertion de la piste 2 entre deux objets plats adjacents, placés à l'intérieur de la cassette de rangement.

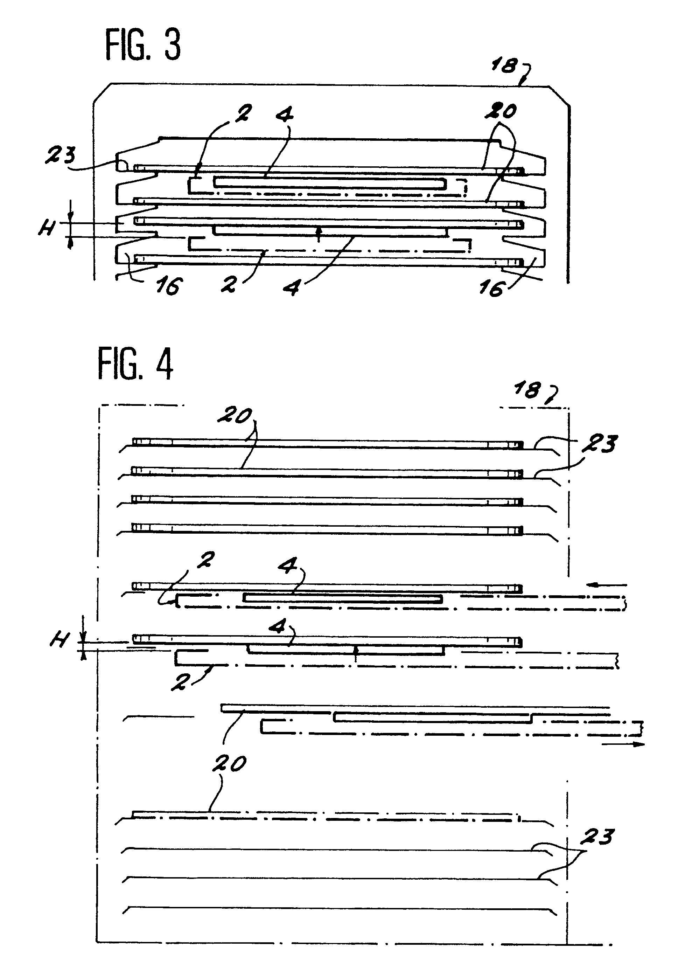

On peut constater l'efficacité et la fiabilité du dispositif selon l'invention, et notamment de ses moyens de préhension, en se reportant aux figures 3 et 4.

Des objets plats 20 sont représentés, placés dans une cassette de rangement 18. L'échelle de ces figures est de l'ordre de grandeur correspondant aux réalisations prévues. On constate que la largeur de la piste 2 est inférieure à l'écart des parois internes 16 de la cassette de rangement 18, de manière à pouvoir être insérée dans celle-ci. De préférence, cette largeur est inférieure à celle de l'espace délimité par les extrémités des supports latéraux 23, de manière à permettre une insertion des pistes 2 dans la cassette de rangement 18, même si ces pistes ne sont pas à la hauteur adéquate, c'est-à-dire en regard d'une paire de supports latéraux 23.

Toutefois, pour effectuer les opérations de chargement ou de déchargement d'un ou de plusieurs objets plats 20 dans la cassette de rangement 18, il y a lieu d'introduire les pistes 2 de manière à ce que leurs surfaces supérieures soient sur des plans situés juste en-dessous de ceux délimités par les surfaces supérieures des supports latéraux 23, sur lesquels se trouvent les objets à saisir, ou sur lesquels on doit poser les objets plats. Le déplacement vertical H de la partie mobile 4 de chaque piste 2 doit être suffisant pour permettre un décollement de chaque objet plat 20, par rapport à ces supports latéraux 23 dans le cas d'un déchargement, et pour le reposer dans le cas d'un déchargement. Dans ces deux cas, il est nécessaire de positionner en hauteur les pistes 2 par rapport à la cassette de rangement 18 de façon très précise.

Sur la figure 4, la flèche orientée vers la gauche symbolise l'insertion d'une piste 2 sous un objet plat 20, la partie mobile 4 de la piste 2 étant en position reposée.

Juste en-dessous, est représentée l'opération de soulèvement de la partie mobile 4 par un mouvement vertical de celle-ci de valeur déterminée H. Cette dernière doit être supérieure à la différence de hauteur initiale entre la surface supérieure de la partie mobile 4 et les surfaces supérieures des supports latéraux 23.

En-dessous, on a montré un déplacement latéral vers la droite, de la piste 2 supportant l'objet plat 20, pour extraire celui-ci de la cassette.

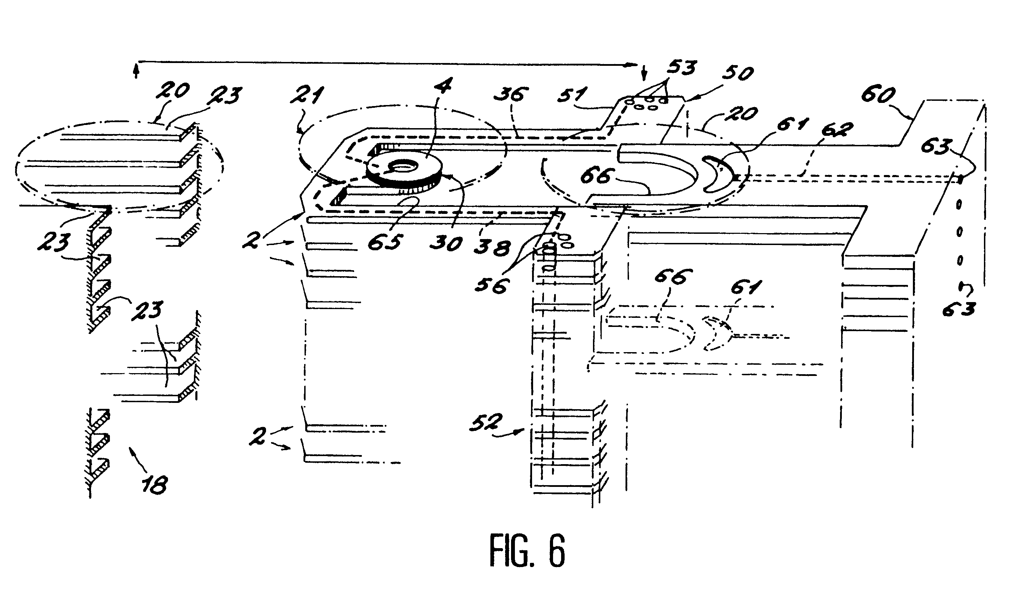

La figure 5 est une vue de dessus en coupe du dispositif selon l'invention à droite, et de la cassette de rangement à gauche.

Cette dernière est représentée avec ses rayonnages constitués chacun de deux supports latéraux 23, sur lesquels est posé un objet plat 20, en l'occurrence une plaque de silicium. Sur la partie droite, un autre objet plat 21 est posé sur une piste 2 de l'ensemble de préhension 50, centré sur la partie mobile 4 de cette piste 2. Une piste de la cassette intermédiaire 60 vient pénétrer les moyens de préhension 50 par l'intermédiaire de deux bras latéraux 66 venant à l'intérieur d'évidements 65 pratiqués dans la piste 2.

Les formes représentées sur cette figure 5 constituent un exemple de réalisation possible de l'interpénétration des moyens de préhension 50 et de la cassette intermédiaire 60. Ces formes ne sont en aucun cas limitatives. D'autres formes peuvent être utilisées, la seule contrainte essentielle concernant ces formes est que l'objet plat 21 puisse reposer, par une simple translation verticale, soit sur la partie mobile 4 de la piste 2, soit sur les deux bras latéraux 66 ou d'autres parties de la piste de la cassette intermédiaire 60. Le conduit 36 de la piste 2 peut également affecter n'importe quelle forme, l'essentiel étant qu'il aboutisse à la cavité centrale 40 du soufflet placé sous la partie mobile 4. Ce conduit 36 est relié à une source de dépression 53 qui peut être logée dans une des deux parois latérales 51 des moyens de préhension 50.

De façon analogue, un orifice 61 peut être pratiqué dans la partie de la piste de la cassette intermédiaire 60 se trouvant sous l'objet plat 21, afin de pouvoir appliquer une succion à ce dernier pour le maintenir pendant les éventuels transferts du dispositif selon l'invention. Cet orifice 61 est relié par un conduit 62 à une autre source de dépression 63 pouvant être placée dans le corps central de la cassette intermédiaire 60.

La figure 6 permet de mieux apprécier la forme que peuvent prendre les moyens de préhension 50. Sur la première piste 2, a été représenté le soufflet 40 supportant la partie mobile 4, sur laquelle le premier objet plat peut être posé. Les évidements 65 séparent le centre de la piste 2 des parois latérales 51 et 52 de l'ensemble de préhension. On constate qu'un espace 57 doit subsister entre ces deux parois latérales 51 et 52, pour que les pistes de la cassette intermédiaire 60 puissent pénétrer sans encombre dans les évidements 65. Les parois latérales 51 et 52 assurent la rigidité de l'ensemble. La largeur des pistes 2 est inférieure à la largeur de l'espace libre entre les supports latéraux des cassettes de rangement.

Les parois latérales 51 et 52 de l'ensemble de préhension 50 permettent de loger les canalisations 53 et 56 reliées à des sources de dépression. Celles-ci sont commandées par des moyens de commande sélective des différents rayonnages de l'ensemble de préhension 50, logés à l'intérieur de celui-ci. Ceci permet d'actionner indépendamment les unes des autres, les parties mobiles 4 des pistes 2 pour saisir ou reposer n'importe quel objet plat placé dans la cassette de rangement 18, ou la cassette intermédiaire 60, ou bien posé sur une piste 2.

Comme le schématise la figure 6, les moyens de préhension 50 et la cassette intermédiaire 60 sont de préférence constitués chacun d'un empilage de N ou M étages. On comprend mieux alors le caractère modulable de la conception de ces deux ensembles qui peut avoir un grand avantage quant à leur fabrication. Il est ainsi aisé de fabriquer différents ensembles de préhension ou cassettes intermédiaires avec un nombre d'étages à chaque fois différent.

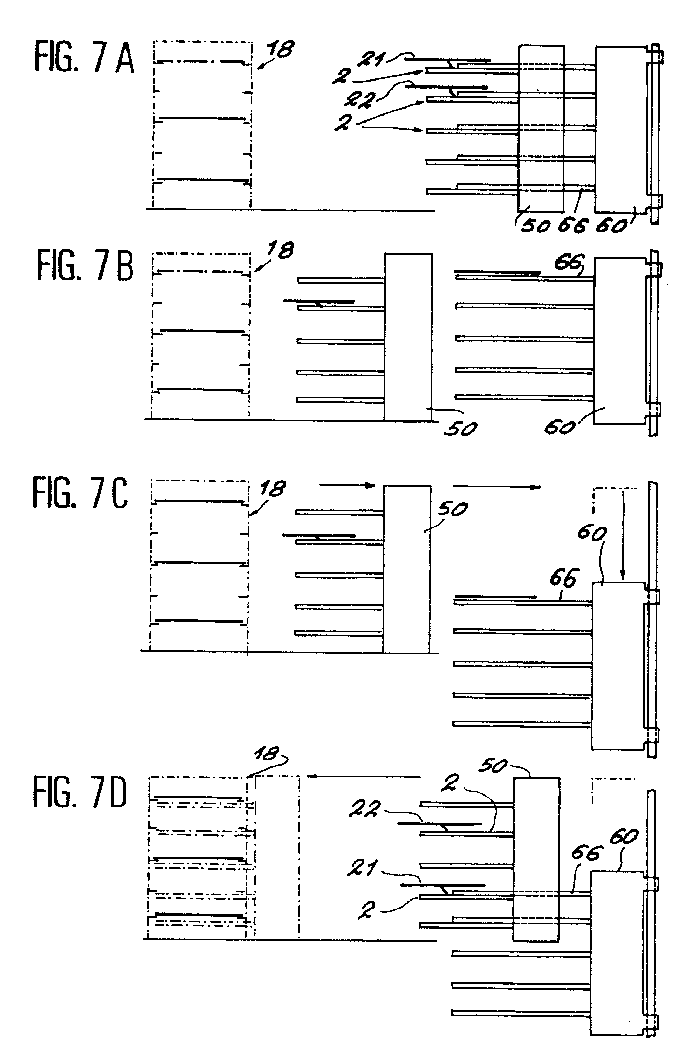

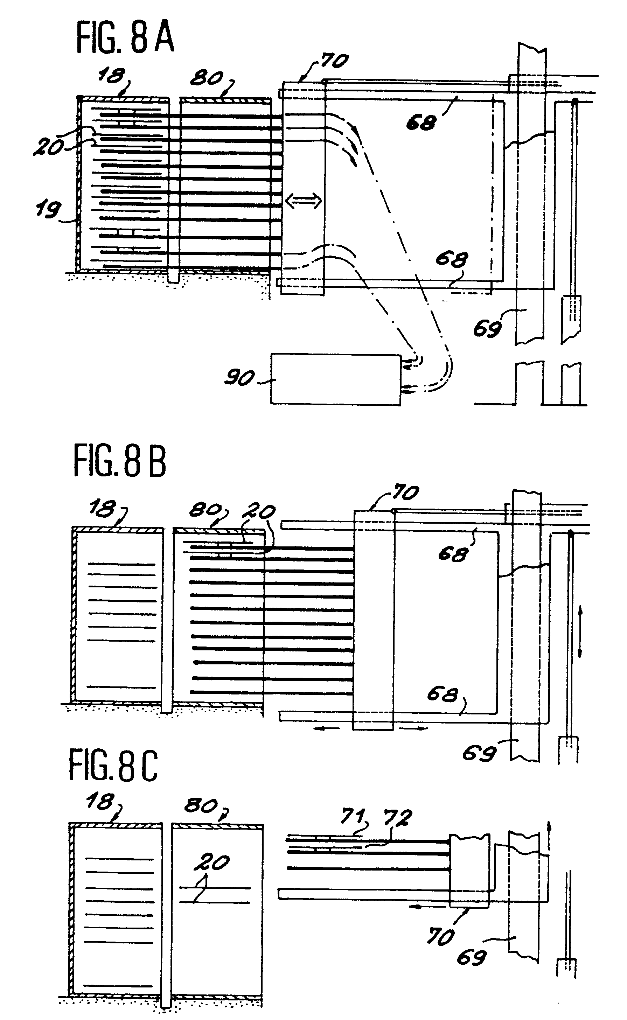

Le dispositif selon l'invention peut être complété par des moyens de translation verticale, appliqués à la cassette intermédiaire, comme le montrent les figures 7A, 7B, 7C et 7D, ou appliqués à l'ensemble de préhension, comme le représentent les figures 8A, 8B et 8C.

En effet, on peut éprouver le besoin de manipuler les objets plats, lors de leur rangement, pour les faire changer de place dans la cassette de rangement 18. Une telle opération peut s'assimiler à celle consistant à battre les cartes d'un jeu de cartes.

La figure 7A montre le problème que permet de résoudre un tel dispositif. Un objet 21 placé sur l'ensemble de préhension 50, et plus précisément sur le premier rayonnage, peut avec l'objet plat 20 placé sur le premier rayonnage de la cassette de rangement 18, créer une interférence lors d'une manipulation du dispositif. En effet, si on désire ranger l'objet plat 22 dans la cassette de rangement 18, il y aura télescopage de ces objets plats 20 et 21 placés sur les premiers rayonnages.

La figure 7B montre le deuxième objet plat 22, soulevé par la partie mobile de la deuxième piste 2, le premier objet plat 21 restant reposé sur les bras latéraux 66 du premier rayonnage de la cassette intermédiaire 60. L'ensemble de préhension 50 est alors avancé pour qu'il n'y ait plus interpénétration de la cassette intermédiaire 60 dans les moyens de préhension 50.

La cassette intermédiaire 60 est montée sur des moyens de translation verticale, représentés par deux paliers coulissants 67. En conséquence, comme le montre la figure 7C, la cassette intermédiaire 60 peut être descendue d'une valeur déterminée. Il est alors possible de positionner le premier objet plat 21 en face d'un rayonnage libre de l'ensemble de préhension 50, en face duquel le rayonnage correspondant de la cassette 18 reste libre, en l'occurrence le quatrième.

La suite de l'opération consiste à faire reculer les moyens de préhension 50 pour obtenir une nouvelle interpénétration de ceux-ci avec la cassette 60. Comme le montre la figure 7D, une fois cette opération réalisée, le premier objet plat 21 se trouvant alors au niveau du quatrième rayonnage des moyens de préhension 50, peut être soulevé par la partie mobile de la quatrième piste 2.

L'ultime opération, non représentée, consiste à effectuer le rangement de l'objet plat 21 sur le quatrième rayonnage de la cassette intermédiaire 18, tout en pouvant effectuer le rangement du deuxième objet plat 22 dans le deuxième rayonnage de la cassette intermédiaire 18. Il est également possible d'effectuer le prélèvement des premier, troisième et cinquième objets plats stockés dans la cassette de rangement 18.

Sur les figures 8A, 8B, 8C, est représentée une deuxième forme de réalisation du dispositif selon l'invention, dans le cadre de l'utilisation des moyens de translation verticale. Cette réalisation prévoit de placer la cassette intermédiaire 80 devant l'ensemble de préhension 70. Ce dernier est donc relié aux moyens de translation verticale. L'ensemble de préhension 70 est monté coulissant en translation horizontale sur des bras de support 68, montés coulissants sur l'arbre de translation verticale 69.

Dans cette réalisation, les pistes 2 sont d'une longueur suffisante pour pouvoir pénétrer à l'intérieur de la cassette de rangement 18 après avoir traversé la cassette intermédiaire 80. Cette dernière est constituée de simples rayonnages superposés maintenus par une ossature périphérique similaire à celle de la cassette de rangement 18, mais sans le fond 19 de celle-ci.

Comme le montrent ces trois figures 8A, 8B et 8C, la cassette intermédiaire 80 peut être placée à demeure devant la cassette de stockage 18.

La figure 8A montre le prélèvement des premier, deuxième, dixième et onzième objets plats 20 stockés dans la cassette de rangement 18. Ce prélèvement se fait toujours par soulèvement du soufflet portant la partie mobile de chaque piste 2.

La figure 8B représente le dépôt des dixième et onzième objets plats 71 et 72 dans la cassette intermédiaire 80, schématisé par le fait que leurs soufflets respectifs sont repliés. Ces dixième et onzième objets plats 71 et 72 peuvent donc être posés sur les rayonnages correspondants de la cassette intermédiaire 80.

En continuant le mouvement de recul de l'ensemble de préhension 70 et en descendant celui-ci, il est possible de remettre les premier et deuxième objets plats 20 sur des rayonnages libres de la cassette intermédiaire 80, différents des premier et deuxième rayonnages. Le passage vers les premier et deuxième rayonnages de la cassette de rangement 18 est alors libre.

Comme le montre la figure 8C, une remontée de l'ensemble de préhension 70 permet de positionner les dixième et onzième objets plats 71 et 72 en face des premier et deuxième rayonnages de la cassette de rangement 18. Une translation non représentée permet alors de déposer ces dixième et onzième objets plats 71 et 72 sur les deux premiers rayonnages de la cassette intermédiaire 18. Comme le schématisent deux flèches, une opération similaire peut être effectuée pour remettre les premier et deuxième objets plats 20 sur les dixième et onzième rayonnages laissés libres dans la cassette de stockage 18. Cette opération peut se faire par translation et redescente de l'ensemble de préhension 70.

Sur la figure 8A, des moyens de commande 90 ont été représentés à l'extérieur de l'ensemble de préhension, ceci pour minimiser l'encombrement de l'ensemble de préhension 70. Ils permettent en outre une télécommande de l'ensemble du dispositif de rangement selon l'invention.

Dans tous les cas de figure, les rayonnages des ensembles de préhension et des cassettes intermédiaires doivent avoir le même entraxe vertical E égal à celui des rayonnages des cassettes pour lesquels leur utilisation est prévue.

Dans la variante utilisant des moyens de translation verticale, il est possible d'utiliser la cassette intermédiaire comme un véritable outil de stockage tampon. Pour atteindre ce but, il suffit de doter cette cassette intermédiaire d'un nombre M suffisant de rayonnages supplémentaires.

Les moyens de translation verticale et les moyens utilisés pour la translation horizontale sont des moyens mécaniques conventionnels.

Les réalisations décrites dans les pages précédentes le sont pour expliquer le concept inventif de l'invention, consistant à utiliser une cassette intermédiaire pour faciliter le rangement d'objets plats dans celle-ci, et éventuellement le brassage des objets plats. L'homme du métier pourra toujours modifier la forme de la cassette intermédiaire ou de l'ensemble de préhension tout en respectant les fonctions attribuées à ces deux ensembles principaux du dispositif selon l'invention.

## Revendications

1. Dispositif de rangement d'objets plats (20) dans une cassette de rangement (18), stockés parallèlement entre eux, posés sur des supports latéraux (23) d'un nombre déterminé (N) de rayonnages et séparés les uns des autres d'un écart déterminé (E), caractérisé en ce qu'il comprend :

– un ensemble de préhension (50, 70) comportant un même nombre (N) de pistes (2) horizontales, séparées les unes des autres du même écart déterminé (E), terminées chacune par une extrémité de préhension (6) où sont placés des moyens de préhension et de lâchage d'un objet plat (20) sur un rayonnage correspondant de la cassette de rangement (18) ;

– une cassette intermédiaire (60, 80) dotée d'un deuxième nombre (M) égal ou supérieur au premier nombre (N) de rayonnages de la cassette de rangement (18), espacés entre eux dudit écart (E) pour accueillir temporairement des objets plats (20, 21, 22, 25) ;

– une translation horizontale relative entre l'ensemble de préhension (50, 70) et la cassette intermédiaire (60, 80) permettant le transfert dans les deux sens d'au moins un objet plat (20) entre l'ensemble de préhension (50, 70) et la cassette intermédiaire (60, 80).

2. Dispositif selon la revendication 1, caractérisé en ce que les moyens de préhension et de lâchage d'un objet plat (20) fonctionnent par soulèvement de la partie mobile (4) de la piste (2) correspondante, le lâchage de l'objet plat (20) se faisant par la redescente de la même partie mobile (4) de la piste (2).

3. Dispositif selon la revendication 2, caractérisé en ce que les moyens de préhension (50, 70) sont constitués chacun d'un soufflet (30) déformable, fixé à la fois à la piste (2) par une première extrémité inférieure (32) et à la partie mobile (4) par une deuxième extrémité supérieure (34) et relié à une source de dépression (51).

4. Dispositif selon l'une des revendications 2 ou 3, caractérisé en ce que chaque rayonnage de la cassette intermédiaire (18) est constitué de deux supports latéraux (23) ménageant un espace entre eux pour permettre l'interpénétration de la piste correspondante de l'ensemble de préhension (50, 70) par translation parallèle aux supports latéraux (23), la surface supérieure de la piste mobile (4) se trouvant très légèrement endessous de la surface supérieure des supports latéraux (23) de l'étage correspondant de la cassette intermédiaire (18), la course verticale (H) de la piste mobile (4), lors de la montée, étant suffisante pour provoquer un décollement d'un objet plat (20) posé sur les supports latéraux de la cassette intermédiaire (60, 80) et, lors d'une redescente de la piste mobile (4), un dépôt de l'objet plat (20) sur les supports latéraux de la cassette intermédiaire (60, 80).

5. Dispositif selon l'une quelconque des revendications 1 à 4, caractérisé en ce qu'il comprend des moyens de commande sélective (90) pour actionner indépendamment les uns des autres, les ensembles de préhension et de lâchage, afin de saisir ou reposer n'importe quel objet plat (20) placé dans la cassette de rangement (18) ou sur la cassette intermédiaire (60, 80) ou étant posé sur une piste (2) de l'ensemble de préhension (50, 70).

6. Dispositif selon la revendication 4, caractérisé en ce que l'interpénétration de l'ensemble de préhension (70) dans la cassette intermédiaire (80) se fait par l'avant des pistes (2) dont la largeur est inférieure à la largeur de l'espace libre entre les supports latéraux de la cassette de rangement (18) et la cassette intermédiaire (80), de manière à pouvoir traverser ces deux cassettes de rangement (18) et intermédiaire (80) dans le même mouvement de translation.

7. Dispositif selon la revendication 6, caractérisé en ce que des moyens de translation verticale de l'ensemble de préhension (70) sont prévus pour venir mettre en correspondance, de façon décalée, des rayonnages respectifs de la cassette intermédiaire (80) et de l'ensemble de préhension (70).

8. Dispositif selon la revendication 4, caractérisé en ce que l'interpénétration de l'ensemble de préhension (50) dans la cassette intermédiaire (60) se fait par des évidements (65) pratiqués à l'arrière de chacune des pistes (2) de l'ensemble de préhension (50), pour permettre à la cassette intermédiaire (60) de venir pénétrer les moyens de préhension (50) par l'arrière jusqu'à la piste mobile (4).

9. Dispositif selon la revendication 8, caractérisé en ce que des moyens de translation verticale de la cassette intermédiaire (60) sont prévus pour venir mettre en correspondance, de façon décalée, les rayonnages respectifs de la cassette intermédiaire (60) et de l'ensemble de préhension (50).

10. Dispositif selon la revendication 9, caractérisé en ce que le deuxième nombre (M) de rayonnages de la cassette intermédiaire (60) est supérieur au premier nombre (N) de pistes (2) de l'ensemble de préhension (50) pour constituer un outil de stockage tampon.

FIG. 1A

FIG. 1B

FIG. 1C

FIG. 1D

FIG. 1E

FIG. 2B

FIG. 2A

FIG. 5

# FIG. 3

# FIG. 4

FIG. 6

FIG. 7 A

FIG. 7 B

FIG. 7 C

FIG. 7 D

## FIG. 8 A

18  80  70

20

19

68

68

69

90

## FIG. 8 B

18  80  20  70

68

68

69

## FIG. 8 C

18  80  71  72

20

70

69

**Office européen des brevets**

# RAPPORT DE RECHERCHE EUROPEENNE

Numéro de la demande

EP 90 40 3785

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 550 242 (UEHARA) <br> * Colonne 3, ligne 56 - colonne 5, ligne 40; figures 5,7 * <br> --- | 1 | B 65 G 65/00 <br> H 01 L 21/00 |
| A | US-A-4 759 681 (NOGAMI) <br> * Abrégé; colonne 3, ligne 58 - colonne 4, ligne 31 * <br> --- | 1 | |
| A | EP-A-0 250 990 (FUJITSU LTD) <br> * Figure 2 * <br> --- | 1 | |
| A | US-A-4 178 113 (BEAVER) <br> * Abrégé * <br> --- | 1 | |
| A | FR-A-2 314 811 (IBM) <br> * Page 5, ligne 15 - page 6, ligne 19; figures 3A-C,6A,B * <br> ----- | 1,2,3 | |

**DOMAINES TECHNIQUES RECHERCHES (Int. Cl.5)**

B 65 G
H 01 L

Le présent rapport a été établi pour toutes les revendications

| Lieu de la recherche <br> LA HAYE | Date d'achèvement de la recherche <br> 22-04-1991 | Examinateur <br> BEERNAERT J.E. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)